# DEMANDE DE BREVET EUROPEEN

(11) **EP 4 163 958 A1**
(43) Date de publication de la demande: **12.04.2023**
(21) Numéro de dépôt: 22200197.6
(22) Date de dépôt: 07.10.2022
(51) Int. Cl.: H01L 21/822, H01L 27/06, H01L 21/683

(54) **PROCEDE DE FABRICATION DE COMPOSANTS SUR LES DEUX FACES D'UN SUBSTRAT**

(30) Priorité: 08.10.2021 FR 2110687
(71) Demandeur: Commissariat à l'énergie atomique et aux énergies alternatives, 75015 Paris (FR)
(72) Inventeur: MONTMEAT, Pierre, 38054 GRENOBLE CEDEX 09 (FR); FOURNEL, Franck, 38054 GRENOBLE CEDEX 09 (FR)
(74) Mandataire: Brevalex

(57) **Abrégé**

Procédé comprenant les étapes suivantes :
i) fabriquer des composants sur une face (120) d'un substrat (100) fixé à un premier substrat temporaire (200),
ii) fixer un deuxième substrat temporaire (300) sur le substrat (100),
iii) retirer le premier substrat temporaire (200),
iv) fabriquer des composants sur une autre face (110) du substrat (100),
les premier et deuxième substrats temporaires ayant des surfaces supérieures à la surface du substrat d'intérêt (100),
lors de l'étape ii), un film adhésif (150) est disposé entre le substrat (100) et le premier substrat temporaire (200) ou entre le substrat (100) et le deuxième substrat temporaire (300),
le film adhésif (150) formant une bande latérale autour du substrat (100) et adhérant aux substrats temporaires,
l'énergie d'adhérence E₁ entre le substrat d'intérêt (100) et le premier substrat temporaire (200) étant supérieure à l'énergie d'adhérence E₂ entre le substrat d'intérêt (100) et le deuxième substrat temporaire (300),
l'énergie d'adhérence E₃₁ entre le premier substrat temporaire (200) et le film adhésif (150) étant inférieure à l'énergie d'adhérence E₃₂ entre le deuxième substrat temporaire (300) et le film adhésif (150).

## Description

### DOMAINE TECHNIQUE

La présente invention se rapporte au domaine général des transferts de films.

L'invention concerne un procédé de transfert de films.

L'invention concerne également une structure formée de plusieurs substrats.

L'invention est particulièrement intéressante puisqu'elle permet de réaliser des composants sur les deux faces d'un même substrat, par exemple, une plaque en silicium.

L'invention trouve des applications dans de nombreux domaines industriels, et notamment pour la fabrication d'imageurs, de microphones ou de systèmes microélectromécaniques (ou MEMs pour 'MicroElectroMechanical Systems').

### ÉTAT DE LA TECHNIQUE ANTÉRIEURE

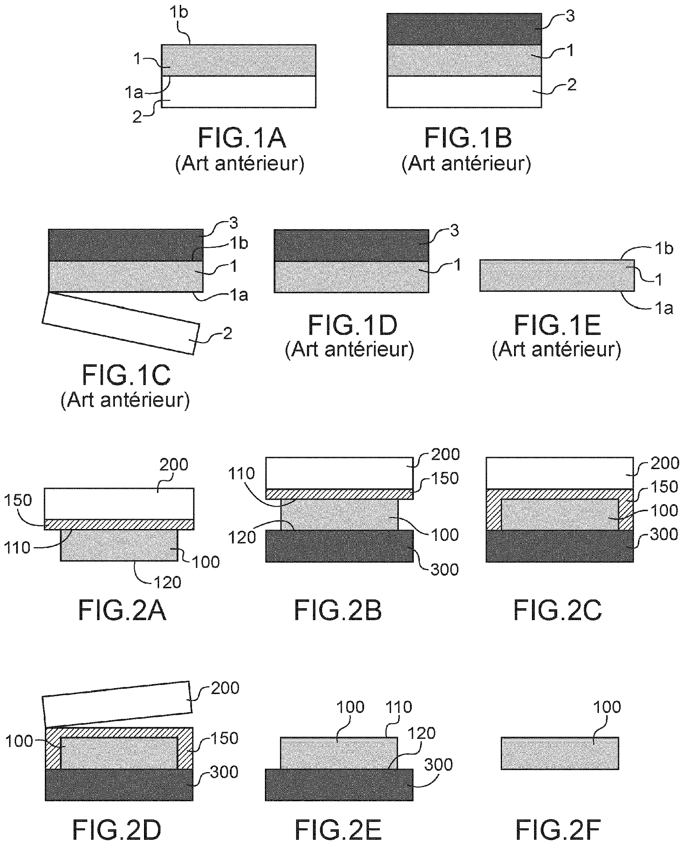

Actuellement, pour réaliser des composants sur les deux faces d'une plaque en silicium, on met en œuvre des techniques de collage temporaire. Par exemple, comme représenté sur les figures 1A à 1E, le procédé de transfert de film peut comprendre les étapes suivantes :
- collage d'un premier substrat temporaire de silicium 2 sur la face avant la d'une plaque en silicium 1 (figure 1A),
- éventuellement amincissement du premier substrat,
- fabrication de composants sur la face arrière 1b de la plaque 1,
- collage d'un deuxième substrat temporaire 3 sur la face arrière 1b de la plaque 1 (figure 1B),
- retrait du premier substrat temporaire 2 (figures 1C et 1D),
- éventuellement amincissement du premier substrat,
- fabrication de composants sur la face avant la de la plaque en silicium 1,
- retrait du deuxième substrat temporaire 3 (figure 1E).

Ce sont les adhérences entre, d'une part, la plaque 1 et le premier substrat temporaire 2 et, d'autre part entre la plaque 1 et le deuxième substrat temporaire 3 qui conditionnent la réussite du transfert (ou retournement).

Ainsi, ce procédé n'est envisageable que si l'adhérence E1 entre la plaque 1 et le premier substrat temporaire 2 est inférieure à l'adhérence E2 entre la plaque 1 et le deuxième substrat temporaire 3. Or, ce n'est pas toujours le cas, parfois E₁>E₂, et un tel procédé de transfert ne peut donc pas être mis en œuvre.

### EXPOSÉ DE L'INVENTION

Un but de la présente invention est de proposer un procédé remédiant aux inconvénients de l'art antérieur et permettant de fabriquer des composants sur les deux faces d'un substrat d'intérêt par transfert de film même si l'énergie d'adhérence entre le substrat d'intérêt et le substrat temporaire collé en face avant est supérieure à l'énergie d'adhérence entre le substrat d'intérêt et le substrat temporaire collé en face arrière.

Pour cela, la présente invention propose un procédé de fabrication de composants sur les deux faces principales d'un substrat d'intérêt comprenant les étapes suivantes :
a) fournir un substrat d'intérêt ayant une première face principale dite face avant et une deuxième face principale dite face arrière,
b) fixer un premier substrat temporaire sur la première face principale du substrat d'intérêt, et éventuellement amincir le substrat d'intérêt,
c) fabriquer des composants sur la deuxième face principale du substrat d'intérêt,
d) positionner un deuxième substrat temporaire sur la deuxième face principale du substrat d'intérêt,
e) solidariser le deuxième substrat temporaire au substrat d'intérêt, de préférence en mettant en œuvre un traitement thermique, pour former un empilement deuxième substrat temporaire/substrat d'intérêt/premier substrat temporaire,
f) retirer le premier substrat temporaire, et éventuellement amincir le substrat d'intérêt,
g) fabriquer des composants sur la première face principale du substrat d'intérêt,
h) éventuellement, retirer le deuxième substrat temporaire,
   lors de l'étape d), le premier substrat temporaire et le deuxième substrat temporaire ayant chacun une surface supérieure à la surface du substrat d'intérêt,
   et un film adhésif étant disposé entre le premier substrat temporaire et le substrat d'intérêt lors de l'étape b) ou entre le substrat d'intérêt et le deuxième substrat temporaire lors de l'étape d),
   moyennant quoi lors de l'étape e), le film adhésif forme une bande latérale autour du substrat d'intérêt et adhère à la fois au premier substrat temporaire et au deuxième substrat temporaire,
   l'énergie d'adhérence E₁ entre le substrat d'intérêt et le premier substrat temporaire étant supérieure à l'énergie de adhérence E₂ entre le substrat d'intérêt et le deuxième substrat temporaire,
   l'énergie d'adhérence E₃₁ entre le premier substrat temporaire et le film adhésif étant inférieure à l'énergie d'adhérence E₃₂ entre le deuxième substrat temporaire et le film adhésif.

L'invention se distingue fondamentalement de l'art antérieur par :
- le positionnement d'un film adhésif entre le premier substrat temporaire et le substrat d'intérêt ou entre le substrat d'intérêt et le deuxième substrat temporaire,
- l'utilisation d'un substrat d'intérêt ayant une surface inférieure à celle des substrats temporaires, ce qui permet de former une bande latérale d'adhésif autour du substrat d'intérêt; lors de l'étape e) par exemple en réalisant un traitement thermique.

Ainsi, on obtient une adhérence entre les deux substrats temporaires via la bande latérale adhésive en périphérie des substrats temporaires. La bande latérale adhésive est autour du substrat d'intérêt puisque ce dernier a une surface inférieure à celle des deux substrats temporaires. On obtient alors une adhérence E₃ entre les deux substrats temporaires. E₃ se décompose en deux adhérences E₃₁ et E₃₂ respectivement entre le premier substrat temporaire et la bande adhésive et entre le deuxième substrat temporaire et la bande adhésive, avec E₃₁ inférieure à E₃₂.

Lors de l'étape f), il est alors possible de séparer le premier substrat temporaire de l'empilement formé par le premier substrat temporaire/substrat d'intérêt/deuxième substrat temporaire, ce qui ne serait pas possible sans la présence du film adhésif. En effet, comme E₃₁<E₃₂ la séparation est initiée à l'interface avec le premier substrat temporaire et continue ensuite le long de cette interface jusqu'à décoller complétement le premier substrat temporaire. Sans ce collage entre les deux substrats temporaires en périphérie du substrat d'intérêt, comme E₁ est supérieure à E₂, l'initiation du décollement ne serait pas le long de la surface du premier substrat temporaire mais au niveau de la surface du deuxième substrat temporaire, ce qui empêcherait la mise en œuvre de l'étape f).

Il est possible d'avoir initialement un substrat d'intérêt ayant une plus petite surface que celles des substrats temporaires ou de réduire les dimensions du substrat d'intérêt au cours du procédé (par exemple après l'étape b).

Selon une première variante de réalisation, le film adhésif est disposé entre le substrat d'intérêt et le premier substrat temporaire, l'énergie d'adhérence E₁ entre le substrat d'intérêt et le premier substrat temporaire étant supérieure à l'énergie d'adhérence E₂ entre le substrat d'intérêt et le deuxième substrat temporaire. L'énergie d'adhérence E₃₂ entre le film adhésif et le deuxième substrat temporaire est supérieure à l'énergie d'adhérence E₃₁ entre le film adhésif et le premier substrat temporaire.

Selon cette première variante de réalisation :
- le substrat d'intérêt et le deuxième substrat temporaire peuvent être fixés l'un à l'autre par un collage direct, ou
- une couche de collage, par exemple en résine, peut être disposée entre le deuxième substrat temporaire et le substrat d'intérêt lors de l'étape d) ; de préférence, la couche de collage ne déborde pas au-delà de la surface du substrat d'intérêt.

Selon une deuxième variante de réalisation, le film adhésif est placé entre le deuxième substrat temporaire et le substrat d'intérêt.

L'énergie d'adhérence E₁ entre le premier substrat temporaire et le substrat d'intérêt étant supérieure à l'énergie d'adhérence E₂ entre le deuxième substrat et le substrat d'intérêt, sans précaution lors d'un décollement c'est bien le deuxième substrat temporaire qui serait décollé et non le premier. Selon l'invention, grâce à la création d'un joint adhésif entre les deux substrats temporaires tel que l'énergie d'adhérence E₃₁ entre le film adhésif et le premier substrat est inférieure à l'énergie d'adhérence E₃₂, lors d'un décollement à l'étape f, c'est le premier substrat temporaire qui sera séparé de la structure substrat d'intérêt / deuxième substrat temporaire.

Selon cette deuxième variante de réalisation, le premier substrat d'intérêt et le substrat temporaire peuvent être fixés l'un à l'autre par un collage direct ou par une couche de collage par exemple en résine. De préférence, la couche de collage ne déborde pas au-delà de la surface du substrat d'intérêt.

Avantageusement, le substrat d'intérêt est en un premier matériau, le premier substrat temporaire est en un deuxième matériau et le deuxième substrat temporaire est en un troisième matériau, le premier matériau, le deuxième matériau et le troisième matériau étant indépendamment choisis parmi le silicium, la silice, le verre, le saphir, les céramiques par exemple SiC, le germanium, un matériau III-V, par exemple AsGa, GaN ou InP, un matériau piézoélectrique, comme LNO et LTO, et un métal, de préférence, le molybdène, le tungstène, le titane, le platine ou cuivre ou un alliage.

Avantageusement, le substrat d'intérêt a une surface dont la plus grande dimension est inférieure d'au moins 200µm, de préférence d'au moins 1cm, à la plus grande dimension de la surface du premier substrat temporaire et/ou à la plus grande dimension de la surface du deuxième substrat temporaire.

Typiquement, les substrats sont des tranches ou 'wafers' (i.e. des plaques circulaires) et la plus grande dimension correspond au diamètre. La bande latérale a alors la forme d'un anneau.

Avantageusement, le film adhésif est en un matériau thermoplastique.

Avantageusement, lors de l'étape e) on chauffe le film adhésif à une température supérieure à la température de transition vitreuse du film adhésif, avec l'application d'une pression, moyennant quoi le film adhésif devient visqueux et coule de part et d'autre du substrat d'intérêt jusqu'à contacter à la fois premier substrat temporaire et le deuxième substrat temporaire, formant ainsi une bande latérale adhésive autour du substrat d'intérêt. Il est possible d'avoir une épaisseur plus importante de polymère en bord de collage pour faciliter cette étape.

Avantageusement, une couche de gestion d'adhérence est positionnée entre le film adhésif et le premier substrat temporaire lors de l'étape b) ou entre le film adhésif et le deuxième substrat temporaire lors de l'étape d).

Par exemple, lorsque la couche de gestion d'adhérence est positionnée entre le film adhésif et le premier substrat temporaire, l'étape b) peut être réalisée selon les sous-étapes suivantes :
- déposer le film adhésif sur la première face principale du substrat d'intérêt,
- déposer une couche de gestion d'adhérence sur le premier substrat temporaire,
- mettre en contact le film adhésif et la couche de gestion d'adhérence,
- éventuellement, réaliser un traitement thermique pour améliorer l'adhésion entre la couche de gestion d'adhérence et le film adhésif.

Avantageusement, la couche de gestion d'adhérence est en un polymère fluoré, tel qu'un fluoroacrylate, ou en un composé organosilicié tel que l'octadécyltrichlorosilane ou le perfluorodécyltrichlorosilane.

Le procédé est simple à mettre en œuvre et peut être mis en œuvre pour de nombreux matériaux.

L'invention concerne également une structure obtenue au cours du procédé précédemment décrit, la structure comprenant successivement :
- un premier substrat temporaire,
- un substrat d'intérêt, ayant une première face principale et une deuxième face principale, la première face principale étant en regard du premier substrat temporaire, la deuxième face principale étant recouverte par des composants,
- un deuxième substrat temporaire,
   le premier substrat temporaire et le deuxième substrat temporaire ayant chacun une surface supérieure à la surface du substrat d'intérêt,
   un film adhésif étant disposé entre le premier substrat temporaire et le substrat d'intérêt ou entre le substrat d'intérêt et le deuxième substrat temporaire, le film adhésif formant une bande latérale autour du substrat d'intérêt et adhérant à la fois au premier substrat temporaire et au deuxième substrat temporaire,
   l'énergie d'adhérence E₁ entre le premier substrat temporaire et le substrat d'intérêt étant supérieure à l'énergie d'adhérence E₂ entre le deuxième substrat temporaire et substrat d'intérêt,
   l'énergie d'adhérence E₃₁ entre le premier substrat temporaire et le film adhésif étant inférieure à l'énergie d'adhérence E₃₂ entre le deuxième substrat temporaire et le film adhésif.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
Les figures 1A à 1E, précédemment décrites, représentent, de manière schématique, différentes étapes d'un procédé selon l'art antérieur.
Les figures 2A à 2F représentent, de manière schématique, différentes étapes d'un procédé selon un mode de réalisation particulier de l'invention.
Les figures 3A à 3F représentent, de manière schématique, différentes étapes d'un procédé selon un autre mode de réalisation particulier de l'invention.
Les figures 4A à 4F représentent, de manière schématique, différentes étapes d'un procédé selon un autre mode de réalisation particulier de l'invention.

Les différentes parties représentées sur les figures ne le sont pas nécessairement selon une échelle uniforme, pour rendre les figures plus lisibles.

En outre, dans la description ci-après, des termes qui dépendent de l'orientation, tels que « sur », « sous », etc. d'une structure s'appliquent en considérant que la structure est orientée de la façon illustrée sur les figures.

### EXPOSÉ DÉTAILLÉ DE MODES DE RÉALISATION PARTICULIERS

Bien que cela ne soit aucunement limitatif, l'invention trouve particulièrement des applications dans le domaine de la microélectronique, et en particulier, pour fabriquer des substrats en silicium dont les deux faces principales sont recouvertes par des composants microélectroniques. En particulier, l'invention est intéressante pour la fabrication de transistor, d'imageurs, de systèmes microélectromécaniques (ou MEMs pour 'MicroElectroMechanical Systems') ou de microphones.

L'invention est transposable à d'autres substrats, notamment à des substrats en silice, verre, saphir, céramique (par exemple SiC), germanium, matériau III-V comme AsGa, le GaN ou l'InP, matériau piézoélectrique comme LNO / LTO ou encore en métal (par exemple molybdène, le tungstène, le titane, le platine ou cuivre) ou en alliage.

Le procédé de fabrication de composants sur les deux faces principales 110, 120 d'un substrat d'intérêt 100 peut être réalisé selon plusieurs modes de réalisation par exemple représentés sur les figures 2A à 2F, 3A à 3F, 4A à 4F.

Les différentes variantes de réalisation du procédé comprennent au moins les étapes suivantes :
a) fournir un substrat d'intérêt 100 ayant une première face principale 110 dite face avant et une deuxième face principale 120 dite face arrière,
b) fixer un premier substrat temporaire 200 sur la première face principale 110 du substrat 100 (fig. 2A, 3A, 4A), et éventuellement amincir le substrat d'intérêt depuis sa deuxième face principale,
   - si le premier substrat temporaire 200 a une surface inférieure ou égale à la surface du substrat d'intérêt 100, réduire la surface du substrat d'intérêt 100 jusqu'à ce que la surface du premier substrat temporaire 200 soit supérieure celle du substrat d'intérêt 100,
c) fabriquer des composants sur la deuxième face principale 120 du substrat 100,
d) positionner un deuxième substrat 300 sur la deuxième face principale 120 du substrat d'intérêt 100 (fig. 2B, 3B, 4B), le deuxième substrat temporaire 300 ayant une surface supérieure à celle du substrat d'intérêt 100,
e) solidariser le deuxième substrat 300 au substrat d'intérêt 100 (fig. 2C, 3C, 4C), de préférence en mettant en œuvre un traitement thermique,
f) retirer le premier substrat temporaire 200 (fig. 2D-2E, 3D-3E, 4D-4E), et éventuellement amincir le substrat d'intérêt depuis sa première face principale,
g) fabriquer des composants sur la première face principale 110 du substrat d'intérêt 100, moyennant quoi on obtient un substrat d'intérêt 100 dont la première face principale 110 et la deuxième face principale 120 sont recouvertes par des composants,
h) éventuellement retirer le deuxième substrat temporaire 300 (fig. 2F, 3F, 4F).

Selon ces différents modes de réalisation particuliers, le substrat d'intérêt 100 fourni à l'étape a) comprend une première face principale 110 (face avant) ayant une première surface et une deuxième face principale 120 (face arrière) ayant une deuxième surface, parallèles ou sensiblement parallèles entre elles. Une face latérale d'une épaisseur e va de la première face principale 110 à la deuxième face principale 120 du substrat d'intérêt 100. La première surface de la première face principale 110 et la deuxième surface de la deuxième face principale 120 ont la même surface dite surface du substrat d'intérêt.

Le premier substrat temporaire 200 comprend une première face principale et une deuxième face principale. La première face principale du premier substrat temporaire est fixée à la première face principale 110 du substrat d'intérêt 100.

Le deuxième substrat temporaire 300 comprend une première face principale et une deuxième face principale. La première face principale du deuxième substrat temporaire 300 est fixée à la deuxième face principale 120 du substrat d'intérêt 100.

Le substrat d'intérêt 100, le premier substrat temporaire 200 et le deuxième substrat temporaire 300 sont par exemple des plaques circulaires.

Le substrat d'intérêt 100 est en un premier matériau, le premier substrat temporaire 200 est un deuxième matériau et le deuxième substrat temporaire 300 est en un troisième matériau.

Le premier matériau, le deuxième matériau et le troisième matériau peuvent être identiques ou différents.

Le premier matériau, le deuxième matériau et le troisième matériau peuvent être identiques ou différents. Le premier matériau, le deuxième matériau et le troisième matériau sont indépendamment choisis parmi les matériaux semi-conducteurs, par exemple le silicium ou le germanium, la silice, le verre, le saphir, les céramiques par exemple le SiC, les matériaux III-V comme AsGa, le GaN ou l'InP, les matériaux piézoélectriques comme LNO / LTO ou les métaux (par exemple molybdène, tungstène, titane, platine ou cuivre) ou les alliages.

Par exemple, le premier matériau, le deuxième matériau et le troisième matériau peuvent être du silicium.

Selon l'invention, le substrat d'intérêt 100 a une surface inférieure à la surface du premier substrat temporaire 200 et à la surface du deuxième substrat temporaire 300.

De préférence, le premier substrat temporaire 200 et le deuxième substrat temporaire 300 ont la même surface.

Lors de l'étape b) et/ou lors de l'étape f), il est possible d'amincir le substrat d'intérêt 100 et/ou de le détourer afin de réduire la surface des faces principales du substrat d'intérêt 100.

La largeur du détourage du substrat d'intérêt 100 est, avantageusement, supérieure ou égale à 200 µm, de façon à assurer une surface de contact suffisante entre le film adhésif 150 et le deuxième substrat temporaire 300. Le détourage dépend de la taille du substrat d'intérêt 100. Pour un substrat circulaire de 300mm de diamètre, on peut choisir par exemple un détourage de 1cm. Pour un substrat plus petit de 50 mm, un détourage compris entre 100µm et 1 mm convient.

Selon l'invention, un film adhésif 150 est disposé entre le premier substrat temporaire 200 et le substrat d'intérêt 100 lors de l'étape b) ou entre le substrat d'intérêt 100 et le deuxième substrat temporaire 300 lors de l'étape d).

Le film adhésif recouvre de préférence toute la surface de la première face du premier substrat temporaire 200 ou toute la surface de la première face du deuxième substrat temporaire 300.

Le film adhésif 150 est, avantageusement, en un matériau thermoplastique. On choisira par exemple le produit Brewer 305 commercialisé par Brewer Science ou TOK zéro newton TWN12000 commercialisé par TOKYO OHKA KOGYO Co.

L'épaisseur du film adhésif 150 est, par exemple, comprise entre 1 µm et 200 µm et de préférence entre 20 µm et 100 µm. L'épaisseur du film adhésif dépend du volume délimité par la paroi latérale du substrat d'intérêt 100, le premier substrat temporaire 200 et le deuxième substrat temporaire 300.

Avantageusement, l'étape e) est réalisée en mettant en œuvre un traitement thermique, moyennant quoi le film adhésif 150 devient visqueux, coule de part et d'autre du substrat d'intérêt 100 et forme une bande latérale autour du substrat d'intérêt 100 et adhère à la fois au premier substrat temporaire 200 et au deuxième substrat temporaire 300. A cette étape, on considère que la viscosité du film adhésif doit être de préférence inférieure ou égale à 10⁻⁴ Pa.s pour obtenir un bon fluage.

La bande latérale est continue depuis le premier substrat temporaire 200 jusqu'au deuxième substrat temporaire 300. La bande latérale est, de préférence, en contact avec la paroi latérale (aussi appelée flanc) du substrat d'intérêt 100. Alternativement, la bande latérale peut ne pas être en contact avec la paroi latérale du substrat d'intérêt 100 (i.e. un vide peut être présent entre la paroi latérale du substrat d'intérêt et la bande latérale).

L'énergie d'adhérence E₃₁ entre le premier substrat temporaire 200 et le film adhésif 150 est inférieure à l'énergie d'adhérence E₃₂ entre le deuxième substrat temporaire 300 et le film adhésif 150. Ainsi, le premier substrat temporaire 200 peut être séparé de l'empilement substrat d'intérêt 100/ deuxième substrat d'intérêt lors de l'étape f).

En l'absence de la bande latérale du film adhésif 150, on aurait un collage direct entre, d'une part, le premier substrat temporaire 200 et le substrat d'intérêt 100 et, d'autre part, entre le deuxième substrat temporaire 300 et le substrat d'intérêt 100, avec l'énergie d'adhérence substrat d'intérêt 100/premier substrat temporaire 200 supérieure ou égale à l'énergie d'adhérence substrat d'intérêt 100/deuxième substrat temporaire 300. Avec cette configuration, il n'est alors pas possible de mettre en œuvre l'étape e).

Selon l'invention, la présence de la bande latérale du film adhésif permet d'avoir une énergie d'adhérence E₃₁ inférieure à E₃₂, ce qui permet l'étape e).

Lors de l'étape e), on appliquera, avantageusement, une force et une température suffisamment élevées à l'assemblage. On pourra appliquer par exemple une force supérieure ou égale à 20kN dans le cas d'un substrat de 300 mm de diamètre et mettre en œuvre une température supérieure ou égale à 200°C.

Selon un mode de réalisation particulier, le film adhésif peut être en contact avec le substrat d'intérêt 100 et avec le premier substrat temporaire 200 (figure 2A). L'étape b) du procédé peut comprendre les sous-étapes suivantes :
- positionner un film adhésif 150 entre la première face principale 110 du substrat d'intérêt 100 et le premier substrat temporaire 200,
- réaliser un traitement thermique,

Alternativement, le film adhésif 150 peut être disposé entre le substrat d'intérêt 100 et le deuxième substrat temporaire 300.

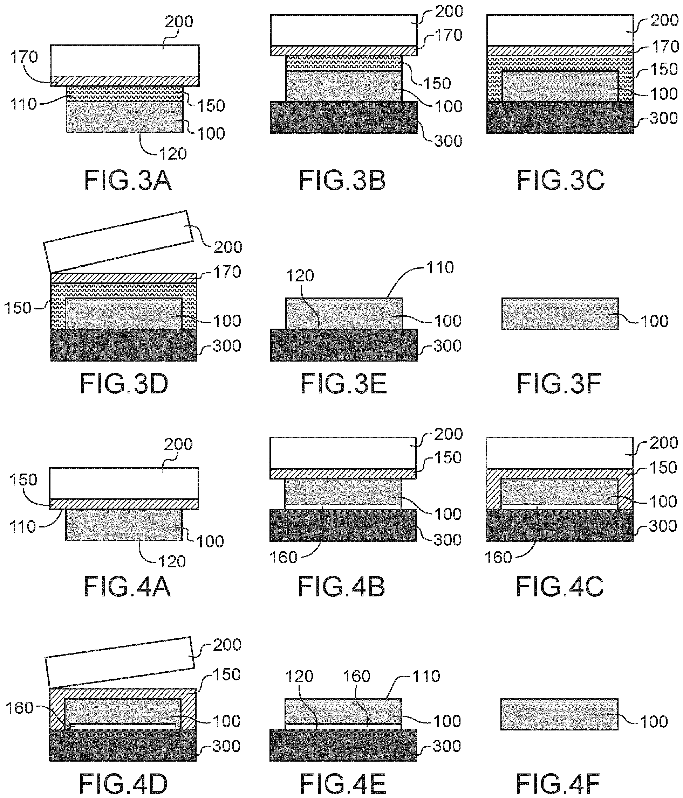

Selon un autre mode de réalisation particulier, une couche de gestion d'adhérence 170 peut être disposée entre le film adhésif 150 et le premier substrat temporaire 200 (figure 3A).

L'énergie d'adhérence globale entre le premier substrat temporaire 200 et le film adhésif 150 peut se décomposer en plusieurs énergies d'adhérence :
- une énergie d'adhérence entre le premier substrat temporaire 200 et la couche de gestion d'adhérence 170, et
- une énergie d'adhérence entre la couche de gestion d'adhérence 170 et le film adhésif 150.

La couche de gestion d'adhérence 170 peut être en un composé organosilicié ayant au moins un atome de chlore tel que l'octadécyltrichlorosilane (OTS), le perfluorodécyltrichlorosilane (FDTS), le perfluorodecyldimethylchlorosilane (FDDMCS).

Par composé organo-silicié, on entend un composé ayant au moins une liaison carbone-silicium.

La couche de gestion d'adhérence 170 peut être en un polymère fluoré, tel qu'un fluoroacrylate ou un polymère de type fluorosilane. On choisira par exemple les polymères fluorés commercialisés par la société 3M sous la référence Novec 2702, Novec 1700 ou Novec 1720 ou encore les polymères fluorés commercialisés par la société Daikin sous la référence Optool.

L'épaisseur de la couche de gestion d'adhérence 170 est, par exemple, comprise entre 1 nm et 1 µm et de préférence entre 5 nm et 100 nm.

Selon ce mode de réalisation particulier, l'étape b) du procédé peut comprendre les sous-étapes suivantes :
- déposer une couche de gestion d'adhérence 170 sur le premier substrat temporaire 200,
- positionner un film adhésif 150 entre la première face principale 110 du substrat d'intérêt 100 et le premier substrat temporaire 200, et plus particulièrement entre la première face principale 110 du substrat d'intérêt 100 et la couche de gestion d'adhérence 170,
- réaliser un traitement thermique.

Il est également possible de positionner la couche de gestion d'adhérence 170 entre la deuxième face principale 120 du substrat d'intérêt 100 et le deuxième substrat temporaire 300.

La couche de gestion d'adhérence peut recouvrir partiellement ou totalement le premier substrat temporaire 200 ou le deuxième substrat temporaire 300.

Si la couche de gestion d'adhérence recouvre partiellement le premier substrat temporaire 200 ou le deuxième substrat temporaire 300, avantageusement, elle ne dépasse pas du substrat d'intérêt 100.

De préférence, la couche de gestion d'adhérence 170 couvre entièrement le substrat 200.

Selon un autre mode de réalisation particulier, d'une part, le film adhésif est disposé lors de l'étape b) entre le substrat d'intérêt 100 et le premier substrat temporaire 200 et, d'autre part, une couche de collage 160 est disposée entre le deuxième substrat temporaire 300 et le substrat d'intérêt (figures 4A à 4E).

La couche de collage 160 ne recouvre pas totalement la première face principale du deuxième substrat temporaire, ainsi le film adhésif 150 peut contacter la première face principale du deuxième substrat temporaire 300 lors de l'étape e).

La couche de collage 160 est par exemple une résine. On choisira par exemple l'une des résines commercialisées par JSR Corporation sous la référence JSR HM8102 et JSR AR 1682J.

L'épaisseur de la couche de collage 160 est, par exemple, comprise entre 1 nm et 100 µm et de préférence entre 10 nm et 10 µm.

Selon ce mode de réalisation particulier, l'étape b) du procédé peut comprendre les sous-étapes suivantes :
- éventuellement, déposer une couche de gestion d'adhérence 170 sur le premier substrat temporaire 200 (non représentée sur les figures),
- positionner un film adhésif 150 entre la première face principale 110 du substrat d'intérêt 100 et le premier substrat temporaire 200 (fig. 4A),
- réaliser un traitement thermique.

Selon cette troisième variante de réalisation, l'étape d) peut comprend les sous-étapes suivantes :
- fournir un deuxième substrat temporaire 300,
- déposer une couche de collage 160 entre le deuxième substrat temporaire 300 et la deuxième face principale 120 du substrat d'intérêt 100, la couche de collage 160 pouvant être déposée sur le substrat d'intérêt 100 et/ou sur une partie de la face principale du deuxième substrat temporaire 300 (Fig. 4B).

Pour ces différents modes de réalisation précédemment décrits, lors de l'étape f), on retire le film adhésif 150. Le film adhésif 150 peut être retiré par un nettoyage au moyen d'un solvant adapté. Le solvant est par exemple choisi parmi les alcools et les hydrocarbures, ou un de leurs mélanges. A titre illustratif, on peut choisir un premier nettoyage à base de D-limonène suivi d'un rinçage à base d'alcool isopropylique (aussi appelé propan-2-ol).

La bande latérale adhésive peut être retirée lors de l'étape f) ou h).

La bande latérale peut être retirée avec le même solvant que celui utilisé pour retirer le film adhésif.

Lors des étapes c) et g), des composants sont fabriqués, respectivement, sur la deuxième face principale 120 du substrat d'intérêt 100 (face arrière) et sur la première face principale 110 du substrat d'intérêt 100 (face avant). La fabrication de ces composants peut comporter par exemple des étapes de lithographie, de gravure ionique, de dépôts, de polissage, d'implantation. Sur une même face principale du substrat d'intérêt, les composants peuvent être identiques ou différents. Les composants de la première face principale du substrat d'intérêt 100 peuvent être identiques ou différents des composants de la deuxième face principale du substrat d'intérêt 100.

Lors de l'étape h), on sépare le deuxième substrat temporaire 300 du substrat d'intérêt 100. Pour cela, la première face principale 110 du substrat d'intérêt 100 peut être fixée à un cadre métallique par exemple de type DISCO avec l'utilisation d'un film adhésif de façon classique en collage temporaire.

En insérant un coin dans l'empilement, on peut séparer le deuxième substrat temporaire 300 du substrat d'intérêt 100. Le substrat 100 peut ensuite subir une étape de découpe pour séparer les différents composants pour être enfin séparé du cadre métallique.

Les substrats temporaires 200, 300 peuvent être réutilisés, par exemple, pour fabriquer des composants sur un autre substrat d'intérêt.

### Exemples illustratifs et non limitatifs de différents modes de réalisation :

Dans les exemples 1 à 3 et 5 qui vont suivre, le premier substrat temporaire 200 et le deuxième substrat temporaire 300 sont des plaques de silicium de 300 mm de diamètre. Le substrat d'intérêt 100 est obtenu par détourage d'une plaque de silicium de 300 mm de diamètre.

Pour l'exemple 4, le premier substrat temporaire 200 et le deuxième substrat temporaire 300 sont des plaques de silicium de 200 mm de diamètre. Le substrat d'intérêt 100 est obtenu par détourage d'une plaque de silicium de 200 mm de diamètre.

### Exemple 1 :

Sur le premier substrat temporaire 200, on étale un film fluoré de Novec 2702 et on recuit l'ensemble à 150°C pendant 30 min pour former une couche de gestion d'adhérence 170.

Au moyen d'une scie diamantée, on détoure une plaque de silicium sur une largeur de 1,5 mm et une profondeur de 200 µm pour former le substrat d'intérêt 100. On forme un film adhésif 150 sur ce substrat d'intérêt 100 en étalant 40 µm de résine Brewer 305 et on vient coller cet ensemble à 210°C avec le premier substrat temporaire 200 de façon à créer une interface entre le film d'adhésif 150 et la couche de gestion d'adhérence 170.

On évalue l'énergie d'adhérence du collage par la méthode décrite dans l'article de Maszara et al. (J. Appl. Phys. 64 (1988) 4943-4950). L'énergie d'adhérence entre le premier substrat temporaire 200 et le substrat d'intérêt 100 est de 0,4 J/m². Dans tous les exemples, les énergies d'adhérence seront déterminées par cette méthode.

On amincit par abrasion mécanique au moyen d'une roue diamantée le substrat d'intérêt 100 à 20 µm. Puis, la surface du substrat d'intérêt 100 subit un nettoyage par voie humide et un polissage. Sur un deuxième substrat temporaire 300, on étale de la résine JSR HM8102 pour avoir une couche de collage 160 de 50 nm d'épaisseur. On effectue un collage direct (défini en tant que collage spontané sans couche liquide intermédiaire) du deuxième substrat temporaire 300 sur l'ensemble substrat d'intérêt 100/premier substrat temporaire 200 par l'intermédiaire de la résine. L'énergie d'adhérence directe entre la résine et le deuxième substrat temporaire 300 est inférieure à 0,2 J/m². Cette énergie n'est pas modifiée par un recuit réalisé entre 100 et 200°C. En particulier, cette adhérence est inférieure à l'adhérence de l'empilement substrat d'intérêt 100/premier substrat temporaire 200. Si on sépare cet assemblage sans précaution, on sépare le deuxième substrat temporaire 300 de l'ensemble substrat d'intérêt 100/premier substrat temporaire 200.

La structure ainsi obtenue comprenant le substrat d'intérêt 100 et les deux substrats temporaires 200, 300 subit un recuit à 200°C sous une force de 20 kN de manière à faire couler l'adhésif 150 et former une bande latérale contactant le deuxième substrat temporaire 300. L'adhérence de l'interface entre la bande latérale du film adhésif 150 et le deuxième substrat temporaire 300 est estimée à 2 J/m² et est beaucoup plus forte que l'adhérence entre le premier substrat temporaire 200 et le substrat d'intérêt 100. En insérant un coin dans cet empilement, on sépare le premier substrat temporaire 200 de l'assemblage. Un nettoyage D-limonène puis alcool isopropylique permet de décaper la surface du substrat d'intérêt 100.

On peut réaliser une étape technologique alors sur le substrat 100. Par exemple on peut réaliser un dépôt de TEOS à 150°C sur la face avant du substrat d'intérêt 100. Puis on vient monter l'ensemble sur un cadre métallique DISCO au moyen d'un film adhésif Furukawa SP-537T-230. En insérant un coin dans l'empilement, on sépare le substrat d'intérêt 100 du deuxième substrat temporaire 300.

### Exemple 2 :

Sur le premier substrat temporaire 200, on étale un film fluoré de Novec 1720 et on recuit l'ensemble à 130°C pendant 5 min pour former une couche de gestion d'adhérence 170.

Au moyen d'une scie diamantée, on détoure une plaque de silicium sur une largeur de 0,5 mm et une profondeur de 200 µm pour former le substrat d'intérêt 100. On étale 40 µm d'adhésif Brewer 305 pour former un film adhésif 150 sur ce substrat 100 et on vient coller cet ensemble à 210°C avec le premier substrat temporaire 200 de façon à créer une interface entre le film d'adhésif 150 et la couche de gestion d'adhérence 170.

On évalue l'énergie d'adhérence du collage entre le premier substrat temporaire 200 et le substrat d'intérêt 100 : 0,4 J/m².

On amincit par abrasion mécanique au moyen d'une roue diamantée le substrat d'intérêt 100 à 20 µm. La surface du substrat d'intérêt 100 subit un nettoyage par voie humide et un polissage. Sur le deuxième substrat temporaire 300, on vient étaler 270 nm de résine JSR AR1682J pour former une couche de collage 160. La résine est détourée sur une largeur de 1 mm. On effectue un collage du deuxième substrat temporaire 300 sur l'ensemble premier substrat temporaire 200/substrat d'intérêt 100 par l'intermédiaire de la résine. Le détourage de 1 mm de la résine JSR AR1682J permet d'assurer un contact entre l'adhésif Brewer 305 et le deuxième substrat temporaire 300. L'adhérence de l'interface deuxième substrat temporaire 300/substrat d'intérêt 100 reste inférieure à 0,2 J/m² quel que soit le recuit réalisé entre 100 et 175°C. En particulier cette adhérence est inférieure à l'adhérence entre le premier substrat temporaire 200 et le substrat d'intérêt 100. Si on sépare cet assemblage sans précaution, on sépare le deuxième substrat temporaire 300 de l'ensemble.

La structure ainsi obtenue subit un recuit à 175°C sous une force de 20 kN. L'adhérence entre l'adhésif 150 et le deuxième substrat temporaire 300 est estimée à 2 J/m² et est beaucoup plus forte que l'interface substrat d'intérêt 100 / deuxième substrat temporaire 300. En insérant un coin dans cet empilement, on sépare le premier substrat temporaire 200 de l'ensemble substrat d'intérêt 100 / deuxième substrat temporaire 300. Un nettoyage D-limonène puis alcool isopropylique permet de décaper la surface du substrat d'intérêt 100.

On réalise un dépôt de SiH₄ à 150°C sur la face avant 110 du substrat d'intérêt 100. Puis on vient monter l'ensemble sur un cadre métallique DISCO au moyen d'un film adhésif Furukawa SP-537T-230. En insérant un coin dans l'empilement, on sépare substrat d'intérêt 100 du deuxième substrat temporaire 300.

### Exemple 3 :

Sur le premier substrat temporaire 200, on étale un film fluoré de Novec 1720 et on recuit l'ensemble à 130°C pendant 5 min pour former une couche de gestion d'adhérence 170.

Au moyen d'une scie diamantée, on détoure une plaque de silicium substrat d'intérêt sur une largeur de 0,5 mm et une profondeur de 200 µm pour former le substrat d'intérêt 100. On étale 40 µm d'adhésif Brewer 305 sur cette plaque 100 formant ainsi un film adhésif 150 et on vient coller cet ensemble à 210°C sur le premier substrat temporaire 200 de façon à créer une interface entre le film d'adhésif 150 et la couche de gestion d'adhérence 170.

On évalue l'énergie d'adhérence du collage : 0,4 J/m².

On amincit par abrasion mécanique au moyen d'une roue diamantée le substrat d'intérêt 100 à 20 µm. La surface du substrat d'intérêt 100 subit un nettoyage par voie humide et un polissage. Après polissage de la surface de substrat d'intérêt 100, on réalise un traitement par une solution aqueuse de HF (5%) de façon à rendre cette surface hydrophobe. Le deuxième substrat temporaire 300 subit également un traitement par une solution aqueuse de HF (5%) de façon à rendre sa surface hydrophobe. On assemble par collage direct le deuxième substrat temporaire 300 sur le substrat d'intérêt 100. L'adhérence de l'interface entre le substrat d'intérêt 100 et le deuxième substrat temporaire 300 reste inférieure à 0,1 J/m² quel que soit le recuit réalisé entre 100 et 250°C. En particulier, cette adhérence est inférieure à l'adhérence de l'empilement substrat d'intérêt 100 / premier substrat temporaire 200. Si on sépare cette assemblage sans précaution, on sépare le deuxième substrat temporaire 300 de l'ensemble substrat d'intérêt 100 / premier substrat temporaire 200.

La structure ainsi obtenue subit un recuit à 200°C sous une force de 20 kN. L'adhérence entre l'adhésif 150 et deuxième substrat temporaire 300 est estimée à 2 J/m² et est beaucoup plus forte que l'interface substrat d'intérêt 100 / deuxième substrat temporaire 300. En insérant un coin dans cet empilement, on sépare le premier substrat temporaire 200 de l'ensemble substrat d'intérêt 100 / deuxième substrat temporaire 300. Un nettoyage D-limonène - alcool isopropylique permet de décaper la surface du substrat d'intérêt 100.

Un recuit de 2 heures à 800°C de l'ensemble substrat d'intérêt 100 / deuxième substrat temporaire 300 renforce l'adhérence de l'interface de collage substrat d'intérêt 100 / deuxième substrat temporaire 300.

### Exemple 4 :

Sur le premier substrat temporaire 200, on étale un film d'OTS (octadecyltrichlorosilane) en solution dans l'isooctane pour former une couche de gestion d'adhérence 170.

Au moyen d'une scie diamantée, on détoure une plaque de silicium sur une largeur de 0,5 mm et une profondeur de 200 µm pour former le substrat d'intérêt 100. On étale 40 µm d'adhésif Brewer 305 sur cette plaque pour former un film adhésif 150. On colle cet ensemble à 210°C sur le premier substrat temporaire 200 de façon à créer une interface entre le film d'adhésif 150 et la couche de gestion d'adhérence 170.

On évalue l'énergie d'adhérence du collage à 0,2 J/m².

On amincit par abrasion mécanique au moyen d'une roue diamantée le substrat d'intérêt 100 à 20 µm. La surface de substrat d'intérêt 100 subit un nettoyage par voie humide et un polissage. Après polissage de la surface de substrat d'intérêt 100, on réalise un traitement par une solution aqueuse d'ammoniaque et d'eau oxygénée (NH₄OH 30%, H₂O₂ 30%, eau dans des proportions 1-1-5) à 70°C pendant 10mn suivie d'une solution aqueuse de HF (5%) de façon à rendre cette surface légèrement rugueuse (2,3nm RMS mesurée en AFM sur un scan de 1^{∗}1µm²) et hydrophobe. Le deuxième substrat temporaire 300 subit également un traitement par une solution aqueuse de HF (5%) de façon à rendre sa surface hydrophobe. On réalise un collage direct du deuxième substrat temporaire 300 sur le substrat d'intérêt 100. L'adhérence de l'interface substrat d'intérêt 100 / deuxième substrat temporaire 300 reste inférieure à 0,1 J/m² quel que soit le recuit réalisé entre 100 et 250°C. En particulier cette adhérence est inférieure à l'adhérence de l'empilement substrat d'intérêt 100 / premier substrat temporaire 200. Si on sépare cette assemblage sans précaution, on sépare deuxième substrat temporaire 300 de l'ensemble substrat d'intérêt 100 / premier substrat temporaire 200.

La structure ainsi obtenue subit un recuit à 200°C sous une force de 20 kN. L'adhérence entre l'adhésif 150 et le deuxième substrat temporaire 300 est estimée à 2 J/m² et est beaucoup plus forte que l'interface substrat d'intérêt 100 / deuxième substrat temporaire 300. En insérant un coin dans cet empilement, on sépare le premier substrat temporaire 200 de l'ensemble substrat d'intérêt 100 / deuxième substrat temporaire 300. Un nettoyage D-limonène - alcool isopropylique permet de décaper la surface du deuxième substrat temporaire 300.

On réalise un recuit de 2 heures à 800°C de l'ensemble substrat d'intérêt 100 / deuxième substrat temporaire 300 de façon à renforcer l'adhérence de l'interface de collage substrat d'intérêt 100 / deuxième substrat temporaire 300.

### Exemple 5 :

Sur le premier substrat temporaire 200, on étale un film de perfluorodecyldimethylchlorosilane (FDDMCS) en solution dans l'isooctane pour former une couche une couche de gestion d'adhérence 170.

Au moyen d'une scie diamantée, on détoure une plaque de silicium sur une largeur de 0,5 mm et une profondeur de 200 µm pour former le substrat d'intérêt 100. On étale sur le substrat d'intérêt 100 un film TOK zéro newton TWM12000 de 100 µm et on vient coller cet ensemble à 180°C sur le premier substrat temporaire 200.

On évalue l'énergie d'adhérence du collage à 1 J/m².

On amincit par abrasion mécanique au moyen d'une roue diamantée le substrat d'intérêt 100 à 40 µm. La surface du substrat d'intérêt 100 subit un nettoyage par voie humide et un polissage. Après polissage de la surface du substrat d'intérêt 100, on réalise un traitement par une solution aqueuse de HF (5%) de façon à rendre cette surface hydrophobe. Le deuxième substrat temporaire 300 subit également un traitement par une solution aqueuse de HF (5%) de façon à rendre sa surface hydrophobe. On assemble par collage direct le deuxième substrat temporaire 300 sur le substrat d'intérêt 100. L'adhérence de l'interface substrat d'intérêt 100 / deuxième substrat temporaire 300 reste inférieure à 0,5 J/m² quel que soit le recuit réalisé entre 100 et 250°C. En particulier cette adhérence est inférieure à l'adhérence de l'empilement substrat d'intérêt 100 / premier substrat temporaire 200. Si on sépare cette assemblage sans précaution, on sépare le deuxième substrat temporaire 300 de l'ensemble substrat d'intérêt 100 / premier substrat temporaire 200.

La structure premier substrat temporaire 200 / substrat d'intérêt 100 / deuxième substrat temporaire 300 subit un recuit à 240°C sous une force de 15 kN. L'adhérence entre l'adhésif 150 et le deuxième substrat temporaire 300 est estimée à 2 J/m² et est beaucoup plus forte que l'interface substrat d'intérêt 100 / deuxième substrat temporaire 300. En insérant un coin dans cet empilement, on sépare le premier substrat temporaire 200 de l'ensemble substrat d'intérêt 100 / deuxième substrat temporaire 300. Un nettoyage à l'acétone permet de décaper la surface du substrat d'intérêt 100.

## Revendications

1. Procédé de fabrication de composants sur les deux faces principales d'un substrat d'intérêt (100) comprenant les étapes suivantes :
a) fournir un substrat d'intérêt (100) ayant une première face principale (110) dite face avant et une deuxième face principale (120) dite face arrière,
b) fixer un premier substrat temporaire (200) sur la première face principale (110) du substrat d'intérêt (100), et éventuellement amincir le substrat d'intérêt (100),
c) fabriquer des composants sur la deuxième face principale (120) du substrat d'intérêt (100),
d) positionner un deuxième substrat temporaire (300) sur la deuxième face principale (120) du substrat d'intérêt (100),
e) solidariser le deuxième substrat temporaire (300) au substrat d'intérêt (100), de préférence en mettant en œuvre un traitement thermique,
f) retirer le premier substrat temporaire (200), et éventuellement amincir le substrat d'intérêt (100),
g) fabriquer des composants sur la première face principale (110) du substrat d'intérêt (100),
h) éventuellement retirer le deuxième substrat temporaire (300),
**caractérisé en ce que** lors de l'étape d), le premier substrat temporaire (200) et le deuxième substrat temporaire (300) ont chacun une surface supérieure à la surface du substrat d'intérêt (100),
et **en ce que** un film adhésif (150) est disposé entre le premier substrat temporaire (200) et le substrat d'intérêt (100) lors de l'étape b) ou entre le substrat d'intérêt (100) et le deuxième substrat temporaire (300) lors de l'étape d),
moyennant quoi lors de l'étape e), le film adhésif (150) forme une bande latérale autour du substrat d'intérêt (100) et adhère à la fois au premier substrat temporaire (200) et au deuxième substrat temporaire (300),
l'énergie d'adhérence E₁ entre le substrat d'intérêt (100) et le premier substrat temporaire (200) étant supérieure à l'énergie de adhérence E₂ entre le substrat d'intérêt (100) et le deuxième substrat temporaire (300),
l'énergie d'adhérence E₃₁ entre le premier substrat temporaire (200) et le film adhésif (150) étant inférieure à l'énergie d'adhérence E₃₂ entre le deuxième substrat temporaire (300) et le film adhésif (150).

2. Procédé selon la revendication 1, **caractérisé en ce que** lors de l'étape e) on chauffe le film adhésif (150) à une température supérieure à la température de transition vitreuse du film adhésif (150), moyennant quoi le film adhésif (150) devient visqueux et coule de part et d'autre du substrat d'intérêt (100) jusqu'à contacter à la fois premier substrat temporaire (200) et le deuxième substrat temporaire (300), formant ainsi une bande latérale adhésive autour du substrat d'intérêt (100).

3. Procédé selon l'une des revendications 1 et 2, **caractérisé en ce que** le film adhésif (150) est disposé entre le premier substrat temporaire (200) et le substrat d'intérêt (100) et **en ce que** le substrat d'intérêt (100) et le deuxième substrat temporaire (300) sont fixés l'un à l'autre par un collage direct.

4. Procédé selon l'une des revendications 1 et 2, **caractérisé en ce que** le film adhésif (150) est disposé entre le premier substrat temporaire (200) et le substrat d'intérêt (100) et **en ce qu'**une couche de collage (160), par exemple en résine, est disposée entre le deuxième substrat temporaire (300) et le substrat d'intérêt (100) lors de l'étape d).

5. Procédé selon l'une des revendications 1 et 2, **caractérisé en ce que** le film adhésif (150) est disposé entre le deuxième substrat temporaire (300) et le substrat d'intérêt (100) et **en ce que** le substrat d'intérêt (100) et le premier substrat temporaire (200) sont fixés l'un à l'autre par un collage direct.

6. Procédé selon l'une des revendications précédentes, **caractérisé en ce que** le film adhésif (150) est en un matériau thermoplastique.

7. Procédé selon l'une quelconque des revendications précédentes, **caractérisé en ce que** le substrat d'intérêt (100) a une surface dont la plus grande dimension est inférieure d'au moins 200µm, de préférence d'au moins 1cm, à la plus grande dimension de la surface du premier substrat temporaire (200) et/ou à la plus grande dimension de la surface du deuxième substrat temporaire (300).

8. Procédé selon l'une quelconque des revendications précédentes, **caractérisé en ce que** le substrat d'intérêt (100) est en un premier matériau, le premier substrat temporaire (200) est en un deuxième matériau et le deuxième substrat temporaire (300) est en un troisième matériau, le premier matériau, le deuxième matériau et le troisième matériau étant indépendamment choisis parmi le silicium, la silice, le verre, le saphir, les céramiques par exemple SiC, le germanium, un matériau III-V, par exemple AsGa, GaN ou InP, un matériau piézoélectrique, comme LNO et LTO, et un métal, de préférence, le molybdène, le tungstène, le titane, le platine ou cuivre ou un alliage.

9. Procédé selon l'une quelconque des revendications précédentes, **caractérisé en ce qu'**une couche de gestion d'adhérence (170) est positionnée entre le film adhésif (150) et le premier substrat temporaire (200) lors de l'étape b) ou entre le film adhésif (150) et le deuxième substrat temporaire (300) lors de l'étape d).

10. Procédé selon la revendication 9, **caractérisé en ce que** la couche de gestion d'adhérence (170) est en un polymère fluoré, tel qu'un fluoroacrylate, ou en un composé organosilicié tel que l'octadécyltrichlorosilane ou le perfluorodécyltrichlorosilane.

11. Structure comprenant successivement :
- un premier substrat temporaire (200),
- un substrat d'intérêt (100), ayant une première face principale (110) et une deuxième face principale (120), la première face principale (110) étant en regard du premier substrat temporaire (200), la deuxième face principale (120) étant recouverte par des composants,
- un deuxième substrat temporaire (300),
**caractérisé en ce que** le premier substrat temporaire (200) et le deuxième substrat temporaire (300) ont chacun une surface supérieure à la surface du substrat d'intérêt (100),
**en ce que** un film adhésif (150) est disposé entre le premier substrat temporaire (200) et le substrat d'intérêt (100) ou entre le substrat d'intérêt (100) et le deuxième substrat temporaire (300),
et **en ce que** le film adhésif (150) forme une bande latérale autour du substrat d'intérêt (100) et adhère à la fois au premier substrat temporaire (200) et au deuxième substrat temporaire (300),
l'énergie d'adhérence E₁ entre le premier substrat temporaire (200) et le substrat d'intérêt (100) étant supérieure à l'énergie d'adhérence E₂ entre le deuxième substrat temporaire (300) et le substrat d'intérêt (100),
l'énergie d'adhérence E₃₁ entre le premier substrat temporaire (200) et le film adhésif (150) étant inférieure à l'énergie d'adhérence E₃₂ entre le deuxième substrat temporaire (300) et le film adhésif (150).
